# EUROPÄISCHE PATENTSCHRIFT

(11) **EP 0 794 508 B1**
(45) Veröffentlichungstag und Bekanntmachung des Hinweises auf die Patenterteilung: **15.09.2004**
(21) Anmeldenummer: 97103336.0
(22) Anmeldetag: 28.02.1997
(51) Int. Cl.: G06K 19/077

(54) **Verfahren zur Herstellung eines Datenträgers mit einem elektronischen Modul**
Process for fabricating a data carrier with an electronic module
Procédé de fabrication de cartes à mémoires avec un module électronique

(30) Priorität: 08.03.1996 DE 19609134
(43) Veröffentlichungstag der Anmeldung: 10.09.1997
(73) Patentinhaber: Giesecke & Devrient GmbH, 81677 München (DE)
(72) Erfinder: Welling, Ando, Dr., 84424 Isen (DE)

(56) Entgegenhaltungen:
- EP-A- 0 140 230
- EP-A- 0 643 366
- EP-A- 0 737 935
- DE-A- 3 130 189
- US-A- 5 198 647

## Beschreibung

Die Erfindung betrifft ein Verfahren zur Herstellung eines mehrschichtigen Datenträgers mit einem integrierten Schaltkreis und wenigstens einem leitend mit dem integrierten Schaltkreis verbundenen Kopplungselement in Form einer Spule zur Kommunikation mit externen Geräten.

Derartige Verfahren sind bereits seit längerem bekannt. Sie werden zur Herstellung von Datenträgern in Form von Chipkarten verwendet, die entweder berührend oder berührungslos mit externen Geräten kommunizieren, um beispielsweise im innerbetrieblichen Bereich als Zugangsberechtigungsausweis in Zugangskontrollsystemen, eingesetzt zu werden. Die Kommunikation des integrierten Schaltkreises mit externen Geräten und die Energieversorgung des integrierten Schaltkreises erfolgen hierbei beispielsweise über eine Spule, kapazitive Elemente oder Kontaktflächen.

Ein derartiges Verfahren zur Herstellung eines Datenträgers wird beispielsweise durch die EP 682 321 A2 gezeigt. Hierbei wird unter anderem aus einer Metallfolie eine Spule ausgestanzt und diese auf einer Trägerschicht des Datenträgers angeordnet. In einem zweiten Schritt wird ein integrierter Schaltkreis, der in einem dafür vorgesehenen Chipträger eingebaut ist, ebenfalls auf der Trägerschicht angeordnet und leitend mit der Spule verbunden. In einem letzten Schritt wird eine oder mehrere Trägerschichten auf die die Spule und den integrierten Schaltkreis enthaltende Trägerschicht auflaminiert, so daß die Spule und der integrierte Schaltkreis hierdurch überdeckt werden.

Die Besonderheit des hierin gezeigten Verfahrens ist insbesondere darin zu sehen, daß die aus der Metallfolie ausgeschnittene Spule instabil und damit schwer handhabbar ist, so daß das Anordnen der ausgeschnittenen Spule auf der dafür vorgesehenen Trägerschicht sich schwierig gestaltet.

Alternativ ist es aus US-A-5 198 647 bekannt, ein Trägermaterial mit einer Metallschicht zu versehen und dann Bereiche der Metallschicht zu entfernen um so die Spule zu formen. Dazu werden die Metallschichtbereiche, die nicht die Spule formen, weggeätzt (siehe Präambeln der unabhängigen Ansprüche 3 und 7).

Ausgehend vom Stand der Technik liegt der Erfindung deshalb die Aufgabe zugrunde, ein Verfahren vorzuschlagen, mit dem kostengünstig und auf einfache Weise ein Datenträger der eingangs genannten Art hergestellt werden kann.

Die Aufgabe wird gemäß den Merkmalen der Ansprüche 1, 3 und 7 gelöst.

Der Grundgedanke der Erfindung ist darin zu sehen, daß eine elektrisch leitende Schicht bereits auf einem stabilisierenden Träger aufgebracht ist, bevor das Kopplungselement in Form einer Spule durch Trennen, Entfernen oder Umwandeln von Schichtmaterial der elektrisch leitenden Schicht mit berührend oder nichtberührend mechanisch wirkenden Mitteln gefertigt wird, wobei die Bearbeitung der leitenden Schicht mit einem mechanischen Trennwerkzeug oder mit einem Laser erfolgt.

Die besonderen Vorteile des Verfahrens sind insbesondere darin zu sehen, daß das fertige Kopplungselement in Form einer Spule leicht handhabbar ist. Darüber hinaus kann die Kontur des Kopplungselementes leicht an die Gegebenheiten des integrierten Schaltkreises angepaßt werden, da sich die Werkzeuge, die zur Bearbeitung der elektrisch leitenden Schicht verwendet werden, einfach auf unterschiedliche Konturen einstellen lassen.

Bei dem erfindungsgemäßen Verfahren wird in einem ersten Schritt ein Träger, der zumindest teilweise mit einer elektrisch leitenden Schicht versehen ist (z. B. mit einer Metallschicht beschichtete Trägerschicht) bereitgestellt. Die leitende Schicht kann hierbei in Ausführungsformen des Verfahrens auf unterschiedlichste Weise aufgebracht werden. So kann beispielsweise auf eine Trägerschicht eine Metallschicht aufgedampft werden, sie kann auch elektrolytisch auf der Trägerschicht abgeschieden werden oder beispielsweise als Metallfolie oder als leitende Kunststoffolie auf die Trägerschicht aufgeklebt werden. Die leitende Schicht kann hierbei aus den unterschiedlichsten Materialien, wie beispielsweise aus Kupfer, aus einer Chrom-Nickel-Legierung oder aber auch aus einem leitenden Kunststoff bestehen. In einem nächsten Schritt wird das Kopplungselement in Form einer Spule durch Trennen, Entfernen oder Umwandeln von Schichtmaterial der elektrisch leitenden Schicht mit berührend oder nichtberührend mechanisch wirkenden Mitteln hergestellt. Die Bearbeitung erfolgt hierbei mit einem Laser oder aber auch mit einem - beispielsweise spitzen - mechanischen Trennwerkzeug. In einem weiteren Schritt wird ein integrierter Schaltkreis auf der Trägerschicht angeordnet und leitend mit der Spule verbunden. In einem letzten Schritt wird wenigstens eine zweite Trägerschicht aufgebracht, so daß wenigstens der integrierte Schaltkreis davon überdeckt wird.

Weitere Vorteile und Weiterbildungen der Erfindung sind der nachfolgenden Figurenbeschreibung zu entnehmen. Hierin zeigen:
- Fig. 1: einen erfindungsgemäßen Datenträger im Aufbruch,
- Fig. 2: Schnitt des Datenträgers gemäß Fig. 1 entlang der Linie A - A,
- Fig. 3: Aufsicht auf eine Trägerschicht des Datenträgers gemäß Fig. 1 und 2 mit einer darauf befindlichen Spule, bei der die Trägerschicht nur teilweise mit einer elektrisch leitenden Schicht überdeckt ist,
- Fig. 4: Aufsicht auf eine Trägerschicht des Datenträgers gemäß Fig. 1 und 2 mit einer darauf befindlichen Spule, bei der die gesamte Trägerschicht mit einer elektrisch leitenden Schicht über deckt ist.

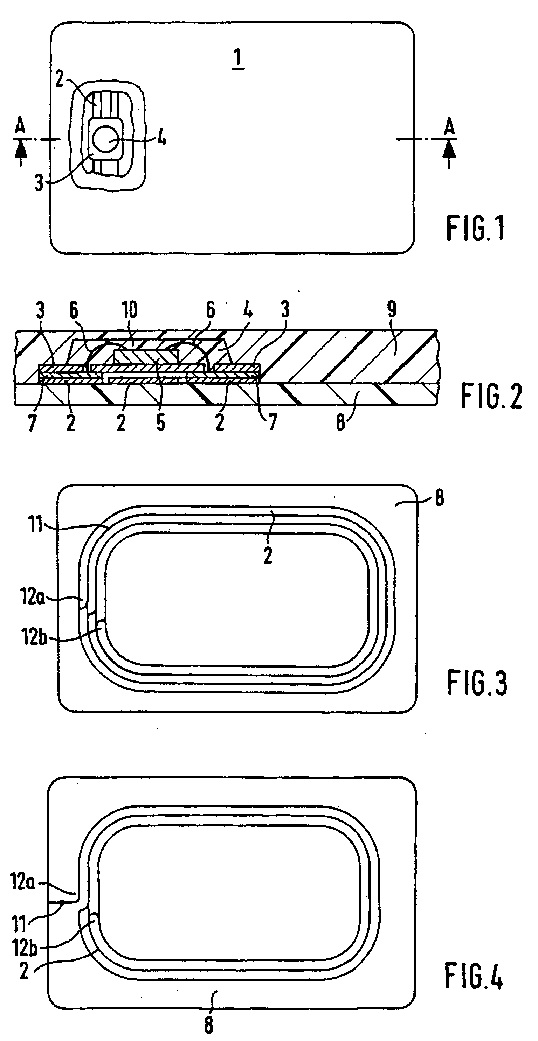

Fig. 1 zeigt einen erfindungsgemäßen mehrschichtigen Datenträger zur berührungslosen Kommunikation, mit einem integrierten Schaltkreis, der Fig. 1 zeigt einen erfindungsgemäßen mehrschichtigen Datenträger zur berührungslosen Kommunikation, mit einem integrierten Schaltkreis, der sich in einem in diesem Zusammenhang mit dieser Figur nicht näher bezeichneten Chipträger 10 befindet, und einem leitend mit dem Schaltkreis verbundenen Kopplungselement in Form einer Spule 2, das sich auf einer der Trägerschichten des Datenträgers befindet, im Aufbruch. Es wird darauf hingewiesen, daß die gezeigten Figuren nicht maßstabsgetreu sind.

Zur Verdeutlichung des Aufbaus zeigt Fig. 2 einen Ausschnitt des Datenträgers gemäß Fig. 1 im Schnitt entlang der Linie A - A. Der Datenträger besteht im wesentlichen aus einer Trägerschicht 8 mit einer darauf befindlichen Spule 2 sowie einer Trägerschicht 9 und einem Chipträger 10. Der Chipträger 10 umfaßt hierbei ein aus einem isolierenden Material bestehendes Trägersubstrat 3, auf dessen einer Seite sich ein integrierter Schaltkreis 5 befindet, und auf dessen anderer Seite sich metallische Kontaktflächen 7 befinden, die durch Fenster im Trägersubstrat 3 hindurch über Bonddrähtchen 6 mit dem integrierten Schaltkreis 5 leitend verbunden sind. Zum Schutz vor mechanischer Beanspruchung sind der integrierte Schaltkreis 5 und die Bonddrähtchen 6 zusätzlich mit einer Vergußmasse 4 vergossen.

Die Herstellung des in der Fig. 2 gezeigten Datenträgers erfolgt hierbei wie folgt. In einem ersten Schritt wird ein Träger (Trägerschicht 8) bereitgestellt, der mit einer elektrisch leitenden Schicht zumindest teilweise versehen ist. Die Trägerschicht 8 besteht aus einem isolierenden Material, wie Kunststoff oder Pappe. Zum Beschichten der Trägerschicht 8 kann beispielsweise eine Metallfolie oder eine Folie aus leitendem Kunststoff über einen Kleber, wie beispielsweise Flüssigkleber, Haftkleber etc., aufgeklebt werden. Die leitende Schicht kann aber auch gleichfalls elektrolytisch auf der Trägerschicht 8 abgeschieden werden. Auch ein Aufdrucken im Thermotransferdruckverfahren oder ein Aufdampfen ist möglich. Die hierbei verwendeten Materialien können unterschiedlichster Natur sein. So kann es sich beispielsweise um Kupfer, um Chrom-Nickel-Legierungen, um Kunststoff oder um metallische Farben handeln.

In einem zweiten Schritt wird durch Trennen, Entfernen oder Umwandeln von Schichtmaterial der elektrisch leitenden Schicht mit berührend oder nichtberührend mechanisch wirkenden Mitteln ein Kopplungselement, hier eine Spule 2, hergestellt. Die Bearbeitung der elektrisch leitenden Schicht kann hierbei beispielsweise durch einen Laserstrahl geschehen, der die leitende Schicht im Bereich des Auftreffens verdampft. Die leitende Schicht kann jedoch auch über ein mechanisches Trennwerkzeug, wie z. B. eine Anreißnadel, mechanisch getrennt werden.

In einem nächsten Schritt wird der integrierte Schaltkreis auf dem Träger (Trägerschicht 8) angeordnet und leitend mit dem Kopplungselement (Spule 2) verbunden. In dem in Zusammenhang mit Fig. 2 gezeigten Ausführungsbeispiel ist hierzu der integrierte Schaltkreis 5 in dem bereits oben beschriebenen Chipträger 10 angeordnet, wobei zur leitenden Verbindung des integrierten Schaltkreises mit der Spule 2 ein leitender Kleber auf die Kontaktflächen 7 des Chipträgers 10 aufgetragen wird und der Chipträger 10 daraufhin über den leitenden Kleber mit den Enden der Spule 2 leitend verklebt wird.

Selbstverständlich muß der integrierte Schaltkreis nicht, wie im Zusammenhang mit Fig. 2 beschrieben, in einem Chipträger untergebracht sein, sondern kann beispielsweise auch direkt mit den Enden der Spule mit einem leitenden Kleber verklebt sein oder beispielsweise neben der Spule 2 angeordnet sein und über Bonddrähtchen mit den Spulenenden verbunden sein. Selbstverständlich kann auch der Chipträger 10 in anderer Form aufgebaut sein. So könnte beispielsweise der Chipträger 10 in der dem Fachmann ebenfalls hinreichend bekannten Leadframe-Technik aufgebaut sein, so daß das Trägersubstrat 3 nicht vorhanden sein muß.

In einem letzten Schritt wird auf die Trägerschicht 8 wenigstens eine Trägerschicht 9 aufgebracht, so daß wenigstens der integrierte Schaltkreis 5 davon überdeckt wird. Bei der im Zusammenhang mit Fig. 2 gezeigten Trägerschicht 9 handelt es sich hierbei um eine Schicht aus spritzgegossenem Material, die bereits im Bereich des Chipträgers 10 eine entsprechend vorgeformte Aussparung aufweist und aufkaschiert wird. Selbstverständlich sind jedoch auch andere Schichten denkbar. So könnte beispielsweise die Trägerschicht 9 aus einer Vielzahl von Schichten bestehen, die entsprechend der Aussparung für den Chipträger 10 Durchbrechungen aufweisen. Es kann gleichfalls auch eine Trägerschicht 9 verwandt werden, in die die Aussparung für den Chipträger 10 nachträglich eingefräst wird. Als Material für die besagte Schicht 9 kommen hierbei unterschiedliche Materialien in Betracht. Beispielsweise kann es sich bei der gezeigten Schicht 9 um Kunststoff oder auch um Pappe handeln. Selbstverständlich kann die Trägerschicht 9 auch im Spritzgußverfahren aufgespritzt werden, indem die Trägerschicht 8 mit dem Chipträger 10 in eine entsprechend geformte Spritzgußform eingebracht wird und mit einem Spritzgußmaterial aufgefüllt wird.

Fig. 3 zeigt ein Halbzeug, mit dem ein Datenträger gemäß Fig. 1 und 2 hergestellt werden kann. Das Halbzeug besteht hierbei aus der bereits oben beschriebenen Trägerschicht 8, auf der eine elektrisch leitende Schicht mit einer ringförmigen Form aufgebracht ist. Zur Herstellung des Halbzeuges wird hierbei aus einer leitenden Folie, wie einer Metallfolie, ein Ring ausgeschnitten und über einen Kleber (Flüssigkleber, Haftkleber etc.) mit der Schicht 8 verklebt. Zur Bildung der Spule wird dann in einem nächsten Schritt die leitende Schicht entlang der Linie 11 wie, oben beschrieben, getrennt, entfernt oder umgewandelt, um hierdurch das Kopplungselement (Spule 2) zu bilden.

Zur Fertigstellung des Datenträgers mit dem in Fig. 3 gezeigten Halbzeug wird, wie bereits oben beschrieben, beim nächsten Schritt der Chipträger 10 über einen leitfähigen Kleber mit den Enden der Spule 12a, 12b leitend verbunden und in einem letzten Schritt die Schicht 9 aufgebracht. Die Kontaktflächen 7 des Chipträgers 10 müssen dazu selbstverständlich derart ausgebildet sein, daß sie tatsächlich auf den Enden 12a, 12b der Spule 2 zum Liegen kommen und nicht die zwischen den Spulenenden 12a, 12b liegenden Windungen der Spule 2 berühren.

Fig. 4 zeigt eine andere Ausführungsform eines Halbzeuges zur Herstellung eines Datenträgers. Im Unterschied zu dem Halbzeug gemäß Fig. 3 ist hierbei die gesamte Schicht 8 mit einer elektrisch leitenden Schicht bedeckt, so daß die leitende Schicht die Außenabmessungen der Trägerschichten des Datenträgers aufweist. Zur Herstellung der Spule wurde die besagte leitende Schicht, wie oben beschrieben, hierbei ebenfalls entlang der Linie 11 getrennt, entfernt oder umgewandelt, so daß auch hierbei zur Fertigstellung des Datenträgers der Chipträger 10 leitend mit den Spulenenden 12a, 12b verbunden werden muß und die Schicht 9 auf das gezeigte Halbzeug auflaminiert werden muß.

Selbstverständlich ist die Erfindung nicht auf die gezeigten Ausführungsformen beschränkt.

Selbstverständlich muß auch der besagte Träger (Trägerschicht 8) nicht die Außenabmessungen des Datenträgers aufweisen, sondern kann auch kleiner ausgestaltet sein. Für diesen Fall sollte die Aussparung in der zweiten Trägerschicht 9 als zweistufige Aussparung vorgesehen werden, um hierdurch sowohl den integrierten Schaltkreis wie auch die Trägerschicht 8 aufnehmen zu können.

## Patentansprüche

1. Verfahren zur Herstellung eines mehrschichtigen Datenträgers, umfassend einen integrierten Schaltkreis und wenigstens ein leitend mit dem integrierten Schaltkreis verbundenes Kopplungselement in Form einer Spule zur Kommunikation mit externen Geräten, wobei das Verfahren folgende Verfahrensschritte umfaßt:
- Bereitstellen eines Trägers, der zumindest teilweise mit einer elektrisch leitenden Schicht versehen ist,
- Herstellen des Kopplungselementes in Form eine Spule aus der leitenden Schicht durch Trennen, Entfernen oder Umwandeln von Schichtmaterial mit berührend oder nichtberührend mechanisch wirkenden Mitteln,wobei die Bearbeitung der leitenden Schicht mit einem Laser oder aber mit einem mechanischen Trennwerkzeug erfolgt.
- Anordnen eines integrierten Schaltkreises auf dem Träger und leitendes Verbinden des integrierten Schaltkreises mit dem Kopplungselement in Form einer Spule,
- Aufbringen wenigstens einer zweiten Trägerschicht mit der wenigstens der integrierte Schaltkreis überdeckt wird.

2. Verfahren nach Anspruch 1, **dadurch gekennzeichnet, daß** zur Erstellung des mit der leitenden Schicht beschichteten Trägers aus einer Metallfolie ein Ring ausgeschnitten wird, der auf einer Trägerschicht angeordnet wird.

3. Mehrschichtiger Datenträger zur berührungslosen Kommunikation mit externen Geräten, umfassend einen integrierten Schaltkreis (5) und wenigstens ein leitend mit dem Schaltkreis verbundenes Kopplungselement in Form einer Spule (2), wobei das Kopplungselement durch eine elektrisch leitende Schicht gebildet ist, die sich auf einem Träger (8) befindet, und wobei zur Bildung des Kopplungselementes Schichtmaterial der elektrisch leitenden Schicht auf dem Träger mit berührend oder nichtberührend mechanisch wirkenden Mitteln getrennt, entfernt oder umgewandelt worden ist, **dadurch gekennzeichnet daß** die Bearbeitung der leitenden Schicht mit einem mechanischen Trennwerkzeug oder mit einem Laser erfolgt ist.

4. Datenträger nach Anspruch 3, **dadurch gekennzeichnet, daß** die leitende Schicht die Außenabmessungen der Trägerschichten des Datenträgers aufweist.

5. Datenträger nach Anspruch 3, **dadurch gekennzeichnet, daß** die leitende Schicht eine ringförmige Form aufweist.

6. Datenträger nach Ansprüchen 3 bis 5, **dadurch gekennzeichnet, daß** die leitende Schicht aus Kupfer oder aus einer Chrom-Nickel-Legierung besteht.

7. Halbzeug zur Herstellung eines Datenträgers gemäß Anspruch 3, umfassend eine Trägerschicht (8) und eine auf der Schicht angeordnete, als Kopplungselement in Form einer Spule (2) ausgebildete elektrisch leitende Schicht, wobei zur Bildung des Kopplungselementes Schichtmaterial der elektrisch leitenden Schicht auf des Trägerschicht mit berührend oder nichtberührend mechanisch wirkenden Mitteln getrennt, entfernt oder umgewandelt worden ist, **dadurch gekennzeichnet daß** die Bearbeitung der leitenden Schicht mit einem mechanischen Trennwerkzeug oder mit einem Laser erfolgt ist.

8. Halbzeug gemäß Anspruch 7, **dadurch gekennzeichnet, daß** die elektrisch leitende Schicht die Außenabmessungen des Trägers aufweist.

9. Halbzeug nach Anspruch 7, **dadurch gekennzeichnet, daß** die elektrisch leitende Schicht eine ringförmige Form aufweist.

10. Halbzeug nach Anspruch 7 bis 9, **dadurch gekennzeichnet, daß** die elektrisch leitende Schicht aus Kupfer oder aus einer Chrom-Nickel-Legierung besteht.

## Claims

1. A method for producing a multilayer data carrier comprising an integrated circuit and at least one coupling element in the form of a coil conductively connected to the integrated circuit for communication with external devices, the method comprising the following method steps:
- supplying a carrier provided at least partly with an electrically conductive layer,
- producing the coupling element in the form of a coil from the conductive layer by separating, removing or transforming layer material with contacting or noncontacting mechanically acting means, the processing of the conductive layer being effected with a laser or with a mechanical separating tool,
- disposing an integrated circuit on the carrier and conductively connecting the integrated circuit to the coupling element in the form of a coil,
- applying at least a second carrier layer with which at least the integrated circuit is covered.

2. A method according to claim 1, **characterized in that** for producing the carrier coated with the conductive layer, a ring is cut out of a metal foil and disposed on a carrier layer.

3. A multilayer data carrier for contactless communication with external devices, comprising an integrated circuit (5) and at least one coupling element in the form of a coil (2) conductively connected to the circuit, whereby the coupling element is formed by an electrically conductive layer located on a carrier (8), and whereby for forming the coupling element, layer material of the electrically conductive layer on the carrier has been separated, removed or transformed with contacting or noncontacting mechanically acting means,
**characterized in that** the processing of the conductive layer has been effected with a mechanical separating tool or with a laser.

4. A data carrier according to claim 3, **characterized in that** the conductive layer has the outer dimensions of the carrier layers of the data carrier.

5. A data carrier according to claim 3, **characterized in that** the conductive layer has an annular form.

6. A data carrier according to claims 3 to 5, **characterized in that** the conductive layer consists of copper or of a chrome-nickel alloy.

7. A semifinished product for producing a data carrier according to claim 3, comprising a carrier layer (8) and an electrically conductive layer disposed on the layer and formed as a coupling element in the form of a coil (2), whereby for forming the coupling element, layer material of the electrically conductive layer on the carrier layer has been separated, removed or transformed with contacting or noncontacting mechanically acting means, **characterized in that** the processing of the conductive layer has been effected with a mechanical separating tool or with a laser.

8. A semifinished product according to claim 7, **characterized in that** the electrically conductive layer has the outer dimensions of the carrier.

9. A semifinished product according to claim 7, **characterized in that** the electrically conductive layer has an annular form.

10. A semifinished product according to claims 7 to 9, **characterized in that** the electrically conductive layer consists of copper or of a chrome-nickel alloy.

## Revendications

1. Procédé pour fabriquer un support de données multicouche, comprenant un circuit intégré et au moins un élément de couplage relié de façon conductrice au circuit intégré sous forme d'une bobine pour la communication avec des appareils externes, dans lequel le procédé comprend les étapes suivantes :
- la préparation d'un support muni au moins partiellement d'une couche électriquement conductrice,
- la fabrication de l'élément de couplage sous la forme d'une bobine à partir de la couche conductrice par séparation, élimination ou transformation du matériau de la couche par des moyens à effet mécanique, avec ou sans contact, l'usinage de la couche conductrice étant réalisé au moyen d'un laser ou au moyen d'un outil de séparation mécanique,
- la disposition d'un circuit intégré sur le support et la liaison de façon conductrice du circuit intégré avec l'élément de couplage sous la forme d'une bobine,
- l'application d'au moins une deuxième couche de support au moyen de laquelle le circuit intégré est recouvert.

2. Procédé selon la revendication 1, **caractérisé en ce que** pour la réalisation du support revêtu de la couche conductrice à partir d'un feuil métallique, on découpe un anneau qui est disposé sur une couche de support.

3. Support de données multicouche pour la communication sans contact avec des appareils externes, comprenant un circuit intégré (5) et au moins un élément de couplage relié de façon conductrice avec le circuit intégré sous la forme d'une bobine (2), dans lequel l'élément de couplage est constitué d'une couche électriquement conductrice qui se trouve sur un support (8), et dans lequel afin de réaliser l'élément de couplage, on sépare, élimine ou transforme le matériau de couche de la couche électriquement conductrice sur le support par des moyens à effet mécanique avec ou sans contact, **caractérisé en ce que** l'usinage de la couche conductrice est réalisé au moyen d'un outil de séparation mécanique ou au moyen d'un laser.

4. Support de données selon la revendication 3, **caractérisé en ce que** la couche conductrice présente les dimensions externes de la couche de support du support de données.

5. Support de données selon la revendication 3, **caractérisé en ce que** la couche conductrice présente une forme annulaire.

6. Support de données selon les revendications 3 à 5, **caractérisé en ce que** la couche conductrice est composée de cuivre ou d'un alliage chrome-nickel.

7. Demi-produit semi-fini pour la fabrication d'un support de données selon la revendication 3, comprenant une couche de support (8) et une couche électriquement conductrice réalisée sous la forme d'une bobine (2) en tant qu'élément de couplage, dans lequel, pour réaliser l'élément de couplage, on sépare, élimine ou transforme du matériau de couche de la couche électriquement conductrice sur la couche de support par des moyens à effet mécanique avec ou sans contact, **caractérisé en ce que** l'usinage de la couche conductrice est réalisé au moyen d'un outil de séparation mécanique ou d'un laser.

8. Demi-produit semi-fini selon la revendication 7, **caractérisé en ce que** la couche électriquement conductrice présente les dimensions externes du support.

9. Demi-produit semi-fini selon la revendication 7, **caractérisé en ce que** la couche électriquement conductrice présente une forme annulaire.

10. Demi-produit selon l'une des revendications 7 à 9, **caractérisé en ce que** la couche électriquement conductrice est composée de cuivre ou d'un alliage chrome-nickel.
